Europäisches Patentamt

European Patent Office

Office européen des brevets

(11) Publication number: **0 117 111 B1**

## (12) EUROPEAN PATENT SPECIFICATION

(45) Date of publication of patent specification: **08.05.91**

(21) Application number: **84300895.4**

(22) Date of filing: **13.02.84**

(51) Int. Cl.⁵: **H01L 23/49**, H01L 23/055, H05K 3/32, H01L 23/532

(54) Semiconductor device assembly.

(30) Priority: **17.02.83 JP 25858/83**

(43) Date of publication of application:
**29.08.84 Bulletin 84/35**

(45) Publication of the grant of the patent:
**08.05.91 Bulletin 91/19**

(84) Designated Contracting States:
**DE FR GB**

(56) References cited:
**EP-A- 0 027 017**
**DE-B- 1 234 817**
**US-A- 3 561 107**
**US-A- 4 338 621**

**PATENTS ABSTRACTS OF JAPAN, vol. 7, no. 27 (E-156)[1172], 3rd February 1983; & JP - A - 57 181 144**

**IBM TECHNICAL DISCLOSURE BULLETIN, vol. 18, no. 5, October 1975, pages 1379-1380, Armonk, US; P.GELDERMANS: "Flexible solder connection and method of fabricating"**

**Integrated Circuits: Materials, Devices and**

Fabrication, W.C. Till & J.T. Luxon, Prentice-Hall, New Jersey, U.S.A., 1982, Section 13.2, page 365, second paragraph

(73) Proprietor: **FUJITSU LIMITED**
**1015, Kamikodanaka Nakahara-ku**
**Kawasaki-shi Kanagawa 211(JP)**

(72) Inventor: **Sugimoto, Masahiro**
**5-27-13, Shonan Takatori**
**Yokosuka-shi Kanagawa 237(JP)**
Inventor: **Wakabayashi, Tetsushi**
**Enzeruhaimu Hiyoshi Dai-1 314, 780, Minowa-cho**
**Kohoku-ku Yokahama-shi Kanagawa 223(JP)**
Inventor: **Muratake, Kiyoshi Musashinakahara Royaruparesu**
**204, 861-1, Kamikodanaka Nakahara-ku**
**Kawasaki-shi Kanagawa 211(JP)**

(74) Representative: **Rackham, Stephen Neil et al**
**GILL JENNINGS & EVERY 53-64 Chancery Lane**
**London WC2A 1HN(GB)**

## Description

The present invention relates to a semiconductor assembly, comprising a package connected to a circuit board.

In recent years, leadless packages also known as chip carriers, have come into increasing use for accommodating integrated circuits (IC), large-scale integrated circuits (LSI), and similar devices. Like conventional packages with outer leads, leadless packages accommodate an IC chip and outer contact pads of the leadless package are electrically connected to a circuit board by soldering. They therefore can be used in popular assembly processes. At the same time, the provision of the contact pads as the conducting elements in place of outer leads enables a more compact structure. Therefore, such packages can be mounted at a higher density on a circuit board, compared with other packages. This highly prized feature has resulted in leadless packages being widely used in a broad range of fields.

There is, however, a problem with mounting the package directly on to the circuit board by a rigid soldering technique in that the electrical connections tend to fracture during heating and cooling. Normally, the package, substrate, and circuit board are formed from different materials having different coefficients of thermal expansion. During the heating required to accomplish the mounting and during normal operating conditions, the package, substrate, and the circuit board contract and expand at different rates, thereby generating stresses. These stresses can fracture the package, substrate, circuit board, or the soldered connection. This problem is compounded the greater the size of the devices on the circuit board. Such breakage, of course, has a fatal effect on the operation of the electronic circuits formed on the circuit board. One proposal to overcome a similar problem when joining a semiconductor chip to its carrier will be discussed in detail with reference to the drawings.

US-A-4338621 discloses a conventional semiconductor device package including connecting leads or pins comprising:
a package in which the semiconductor chip is mounted; and,
a plurality of conductor pads provided on the outer surface of the package, and,
a plurality of conductor pins brazed to the conductor pads and projecting substantially normally away from them.

The outer pins provided on the package are inserted into the holes of a circuit board. However, the use of holes for insertion of the outer pins means a reduction of pin density and an increase of the package size.

According to this invention a semiconductor device assembly comprises:
a semiconductor chip;
a package in which the semiconductor chip is contained and mounted;
a plurality of conductor pads provided on the outer surface of the package and electrically connected to the chip;
a circuit board having a plurality of contact pads in locations corresponding to those of the conductor pads, and
a plurality of conductor pins extending substantially normally between the conductor pads and the contact pads, the conductor pins being made of a low thermal expansion coefficient alloy and being brazed to the conductor pads at one end and soldered to the contact pads at the other end, the conductor pins electrically and mechanically connecting the package to the circuit board, whilst, at the same time accommodating differing thermal expansion of the package and the circuit board.

Particular embodiments of semiconductor devices in accordance with this invention will now be described and contrasted with the prior art with reference to the accompanying drawings; in which:-

Figure 1A is a partially sectioned side elevation of a conventional semiconductor device assembly;

Figure 1B is an underplan of the conventional semiconductor package;

Figure 2 is a side elevation of another conventional semiconductor device;

Figure 3 is an exploded cross-section through a further conventional semiconductor device assembly;

Figure 4 is a partly sectioned side elevation of an embodiment of the present invention;

Figure 5A is a partly sectioned side elevation of an embodiment of a semiconductor device assembly according to the present invention;

Figure 5B is a cross-section to a larger scale of the connecting portions of the embodiment in accordance with this invention;

Figure 6A is a partly sectioned side elevation of another embodiment according to the present invention; and,

Figure 6B is an underplan of the package shown in Figure 6A.

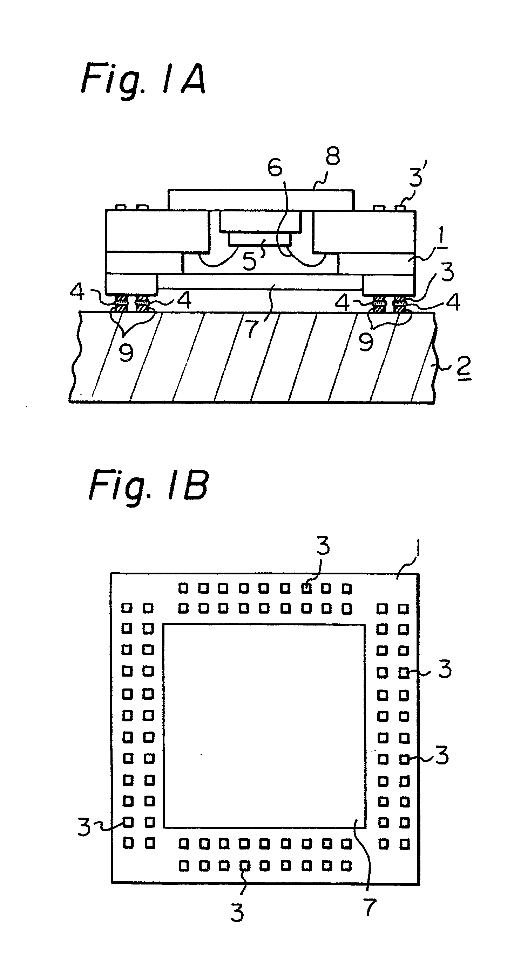

Before describing the preferred embodiments of the invention, an explanation will be made of the prior art for comparative purposes with reference to Figures 1A to 3.

Figure 1A is a partial cross-sectional view of a conventional semiconductor device assembly comprising a plurality of LSI's in packages and a circuit board.

In Figure 1A, there is a package 1 electrically connected to a circuit board 2 through conductor pads 3 and solder 4. Reference numerals 5, 6, 7 and 8 denote an IC chip, wiring, a cap, and a heat sinking plate, respectively.

There are a plurality of conductor pads 3, for example, from 200 to 300, on the package. Connecting electrodes 9 provided on the circuit board 2 are connected to the conductor pads 3 of the package 1 by the solder 4, which has a thickness of about 50 $\mu$m.

When thermal shock is generated during the operation of the circuit, the soldered connecting portion sometimes breaks, e.g., the solder cracks and falls off or the connecting electrode 9 are separated from the circuit board 2. The main reason for the heat-induced breakage is that the circuit board 2 is made of epoxy, polyimide, or other organic resins, which have a large thermal expansion coefficient, while the package 1 is made of ceramic, which has a small thermal expansion coefficient. Thus, the stress is given to the soldered connecting portion. The circuit board 2 can be made of ceramic too, which would eliminate the stress problem of breakage of the soldered connecting portions.

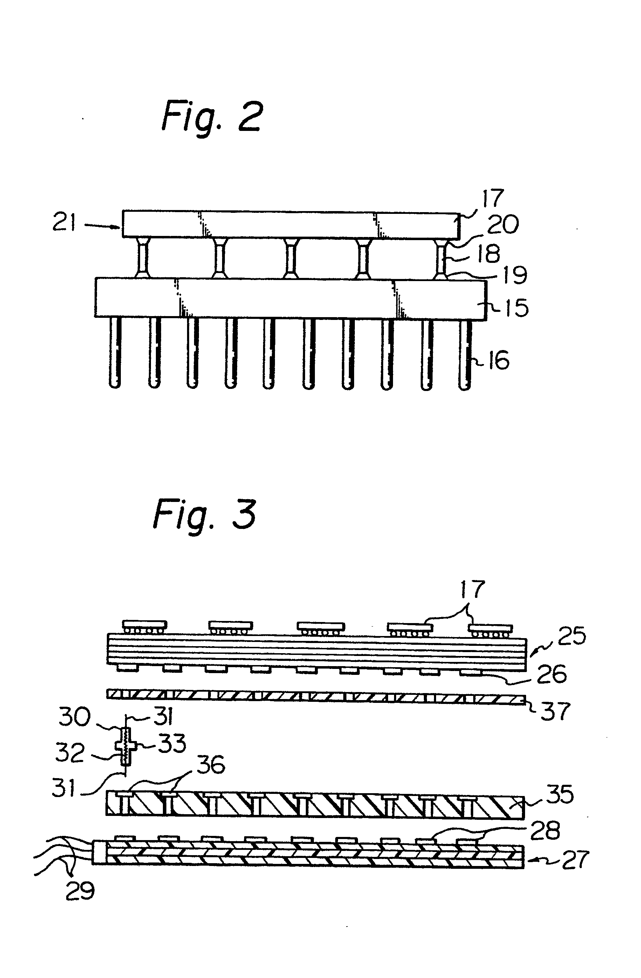

Figure 2 is a schematic view of a semiconductor device disclosed in IBM Technical Disclosure Bulletin Vol. 18 No. 5 October 1975 PP 1379-1380.

In Fig. 2, a semiconductor device 17 is mounted on and connected to a carrier 15 provided with pins 16 through a plurality of flexible strands 18. The bottom ends of the flexible strands 18 are aligned with solder mounds 19 on the top surface of the carrier 15. The top ends of the flexible strands 18 are connected to solder mounds 20 on the semiconductor device 17.

In this structure, the flexible strands form an electrical connection between the package and substrate. They are typically formed of thin copper wire. The strands are not, however, strong enough to be used advantageously as connecting portions between a package and circuit board. That is, since the strands are flexible, it becomes very complicated to assemble these flexible strands 18 to the semiconductor device 17 and the carrier 15. In fact, this publication discloses a complicated method where an special interposer 16 is used for assembling. And also, due to flexible strands 18, the structure is weak when subjected to horizontal forces 21.

Figure 3 shows a conventional semiconductor device assembly disclosed in IBM Technical Disclosure Bullet vol. 19 No. 4 September 1976 PP 1270-1271.

As shown in Fig. 3, a multilayer ceramic substrate 25 with semiconductor devices 17 mounted on the top surface is provided with a plurality of pads 26 on the bottom surface. The multilayer ceramic substrate 25 is electrically connected to a multilayer laminated input/output distribution board 27 provided with pads 28 and wiring 29 through a spring-biased pin contact element 30 which includes a pair of slidably mounted pins 31 biased by a suitable spring 32 including a flange 33. The spring-biased pin contact element 30 is mounted in a socket board 35 provided with a suitable aperture 36. A socket retainer board 37 is disposed over the element 30 retaining it in position. Such a structure is not suitable for high density integration. The reason for that is that the socket board 35 must include the apertures 36 to accommodate the flanges 33. Making apertures for connecting pins and flanges means a reduction of pin density and an increase of the package size of the semiconductor device.

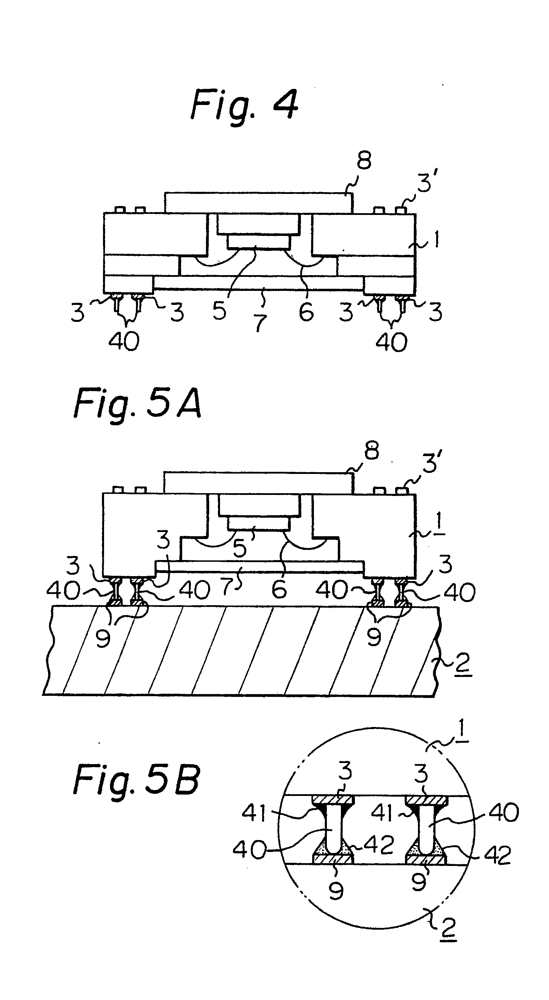

Figure 4 is a cross-sectional view of an embodiment of a package according to the present invention.

In Fig. 4, a package 1 is provided with conductor pins 40 through conductor pads 3. The conductor pins 40 are brazed to the conductor pads 3. The same elements as in Fig. 1A are denoted by the same reference numerals.

The package of Fig. 4 is soldered through the conductor pins 40 to pads 9 provided on the top surface of the circuit board 2, as shown in Fig. 5A.

Figure 5B is an enlarged cross-sectional view of the connecting portions shown in Fig. 5A.

In Fig. 5B, the package 1 and the circuit board 2 have conductor pads 3 and 9 on the respective surface thereof. The conductor pads 3 of the package 1 are formed as a metallized layer during sintering of the ceramic substrate and are plated with nickel. The conductor pins 40 are brazed to the metallized conductor pads 3 with silver alloy 41, such as silver and copper, at a brazing temprature of 800°C to 850°C, the conductor pins 40 are fixed substantially normally to the surface of the conductor pads 3. Then, the surface of the conductor pads 3, conductor pins 40, and silver alloy 41 are generally plated with nickel and gold, i.e., two plating layers. Further conductor pins 3' are provided on the other side of the package. These are used for test pins.

In mounting the package 1 on the circuit board 2, the conductor pins 40 are soldered to conductor pads 9 of the circuit board 2 using solder 42 at a well-known soldering temperature of, for example, 150°C to 200°C. The conductor pads 9 consist of a copper layer plated with soft solder consisting of, for example, lead or tin alloy, and the like.

If the conductor pads 3 are 0.2 to 0.25 mm square, conductor pins 40 having a length of 0.5 to 1.5 mm and a diameter of 0.1 to 0.2 mm are preferably used.

The conductor pins are made of a low thermal expansion coefficient alloy such as Iron-Nickel alloy, Iron-Nickel-Cobalt alloy, tungsten, molybdenum, or copper alloy.

The structure shown in Fig. 4 has the merits that when the package is electrically connected to the circuit board or the like, the thermal stress generated during the operation of the assembly can be absorbed by the conductor pins 40 since they act as buffers of thermal stress. Thus, fractures of connecting portions can be prevented.

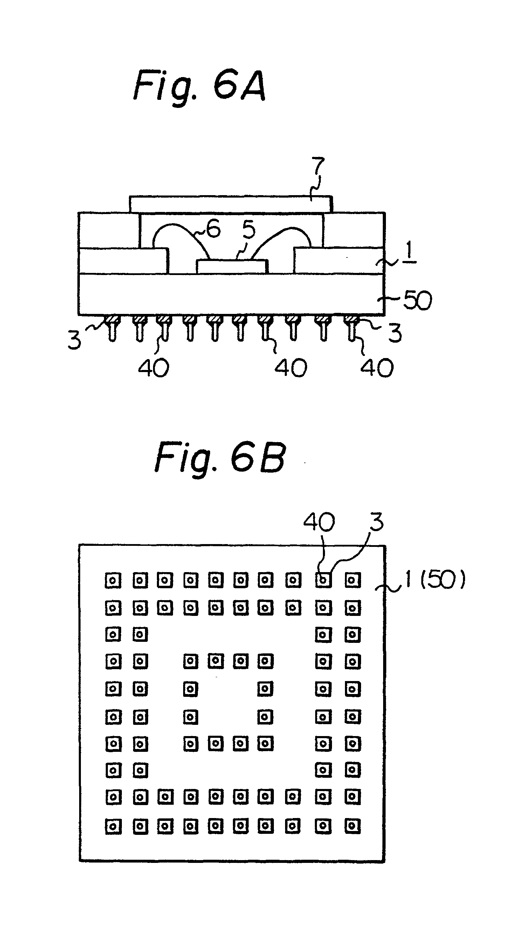

Figure 6A is a cross-sectional view of another embodiment of a package according to the present invention. Figure 6B is a schematic plan view of Fig. 6A.

As illustrated in Figs. 6A and 6B, there are provided conductor pads 3 provided with conductor pins 40 on almost the entire back surface of the package 1. In this embodiment, the semiconductor chip 5 is mounted on the base substrate 50 and the conductor pins 40 are provided on the same base substrate 50. Furthermore, this base substrate comprises a multi-layer ceramic substrate in which signal lines and plated through holes are provided for connection between the chip 5 and the conductor pin 40. Therefore, the conductor pins 40 can be provided on the entire back surface of the package 1. The conductor pins 40 are brazed to the conductor pads 3 as explained above. Such a package structure has the same effect as that explained in Figs. 4 and 5A.

Since the present invention uses not the hole connection type but the contacting connection type, which is comparable to the leadless package type, where the chip carrier has outer pads, not pins, the conductor pins' density thereof is much higher than that of the conventional package. This means the size of the package can be small and also the density of the semiconductor device packages on the circuit board is high.

## Claims

1. A semiconductor device assembly comprising:
a semiconductor chip (5);
a package (1, 7, 8) in which the semiconductor chip (5) is contained and mounted;
a plurality of conductor pads (3) provided on the outer surface of the package (1, 7, 8) and electrically connected to the chip (5);
a circuit board (2) having a plurality of contact pads (9) in locations corresponding to those of the conductor pads (3), and
a plurality of conductor pins (40) extending substantially normally between the conductor pads (3) and the contact pads (9), the conductor pins (40) being made of a low thermal expansion coefficient alloy and being brazed to the conductor pads (3) at one end and soldered to the contact pads (9) at the other end, the conductor pins (40) electrically and mechanically connecting the package (1, 7, 8) to the circuit board (2), whilst, at the same time accommodating differing thermal expansion of the package (1, 7, 8) and the circuit board (2).

2. A semiconductor device assembly according to claim 1, wherein the conductor pads (3) are brazed to the conductor pins (40) using a silver alloy.

3. A semiconductor device assembly according to claim 2, wherein the brazing of the pin (40) to the pads (3) is carried out at a temperature in a range from 800°C to 850°C.

4. A semiconductor device assembly according to any one of the preceding claims, wherein the conductor pads (3) and the conductor pins (40) are provided over substantially the entire back surface (7) of the package (1, 7, 8).

5. A semiconductor device assembly according to any one of the preceding claims, wherein the conducting pins (40) have a length in a range from 0.5 to 1.5 mm and a diameter in a range from 0.1 to 0.2 mm.

## Revendications

1. Assemblage de dispositif semiconducteur comprenant :
une puce semiconductrice (5) ;
un boîtier (1, 7, 8) dans lequel la puce semiconductrice (5) est contenue et montée ;
une pluralité de plots conducteurs (3) prévus sur la surface externe du boîtier (1, 7, 8) et connectés électriquement à la puce (5) ;
une plaquette de circuit imprimé (2) comportant une pluralité de plots de contact (9) en des emplacements qui correspondent à ceux des plots conducteurs (3) ; et
une pluralité de broches conductrices (40) s'étendant sensiblement perpendiculairement entre les plots conducteurs (3) et les plots de contact (9), les broches conductrices (40) étant réalisées en un alliage présentant un coefficient de dilatation thermique faible et étant brasées sur les plots conducteurs (3) au niveau d'une extrémité et soudées aux plots de contact (9) au niveau de l'autre extrémité, les broches conductrices (40) reliant électriquement et mécaniquement le boîtier (1, 7, 8) à la plaquette de circuit imprimé (2) tout en s'adaptant dans le même temps aux dilatations thermiques différentes du boîtier (1, 7, 8) et de la plaquette de circuit imprimé (2).

2. Assemblage de dispositif semiconducteur selon la revendication 1, dans lequel les plots conducteurs (3) sont brasés sur les broches conductrices (40) en utilisant un alliage d'argent.

3. Assemblage de dispositif semiconducteur selon la revendication 2, dans lequel le brasage de la broche (40) sur les plots (3) est réalisé à une température qui s'inscrit dans une fourchette de 800° C à 850° C.

4. Assemblage de dispositif semiconducteur selon l'une quelconque des revendications précédentes, dans lequel les plots semiconducteurs (3) et les broches conductrices (40) sont positionnés sur sensiblement la totalité de la surface arrière (7) du boîtier (1, 7, 8).

5. Assemblage de dispositif semiconducteur selon l'une quelconque des revendications précédentes, dans lequel les broches conductrices (40) ont une longueur qui s'inscrit dans une fourchette de 0,5 à 1,5 mm et ont un diamètre qui s'inscrit dans une fourchette de 0,1 à 0,2 mm.

**Ansprüche**

1. Halbleitervorrichtungsanordnung mit:
einem Halbleiterchip (5);
einer Packung (1, 7, 8), in der das Halbleiterchip enthalten und montiert ist;
einer Vielzahl von Leitungsanschlußflecken (3), die auf der äußeren Oberfläche der Packung (1, 7, 8) vorgesehen und elektrisch mit dem Chip verbunden sind;
einer Schaltungskarte (2), die eine Vielzahl von Kontaktanschlußflecken (9) an Orten hat, die jenen der Leitungsanschlußflecken (3) entsprechen, und
einer Vielzahl von Leitungsstiften (40), die sich im wesentlichen senkrecht zu den Leitungsanschlußflecken (3) und den Kontaktanschlußflecken (9) erstrecken, wobei die Leitungsstifte (40) aus einer Legierung mit niedrigem thermischen Expansionskoeffizienten hergestellt sind und an einem Ende mit den Leitungsanschlußflecken (3) hartgelötet sind und an dem anderen Ende mit den Kontaktanschlußflecken (9) verlötet sind, die Leitungsstifte (40) elektrisch und mechanisch die Packung (1, 7, 8) mit der Schaltungskarte (2) verbinden, während sie gleichzeitig unterschiedliche Wärmeexpansion der Packung (1, 7, 8) und der Schaltungskarte (2) auffangen.

2. Halbleitervorrichtungsanordnung nach Anspruch 1, bei der die Leitungsanschlußflecken (3) mit den Leitungsstiften (40) unter Verwendung einer Silberlegierung hartgelötet sind.

3. Halbleitervorrichtungsanordnung nach Anspruch 2, bei der das Hartlöten des Stiftes (40) an die Anschlußflecken (3) bei einer Temperatur im Bereich von 800° C bis 850° C durchgeführt ist.

4. Halbleitervorrichtungsanordnung nach einem der vorhergehenden Ansprüche, bei der die Leitungsanschlußflecken (3) und die Leitungsstifte (40) im wesentlichen auf gesamten rückseitigen Oberfläche (7) der Packung (1, 7, 8) vorgesehen sind.

5. Halbleitervorrichtungsanordnung nach einem der vorhergehenden Ansprüche, bei der die leitenden Stifte (40) eine Länge im Bereich von 0,5 bis 1,5 mm und einen Durchmesser im Bereich von 0,1 bis 0,2 mm haben.

*Fig. IA*

*Fig. IB*

# Fig. 2

# Fig. 3

*Fig. 4*

*Fig. 5A*

*Fig. 5B*

# Fig. 6A

# Fig. 6B